Europäisches Patentamt

European Patent Office

Office européen des brevets

(11) Veröffentlichungsnummer: **0 172 426 B1**

(12) **EUROPÄISCHE PATENTSCHRIFT**

(45) Veröffentlichungstag der Patentschrift: 17.04.91

(21) Anmeldenummer: 85109144.7

(22) Anmeldetag: 23.07.85

(51) Int. Cl.⁵: **C30B 11/00, C30B 29/06**

(54) **Verfahren und Vorrichtung zur taktweisen Herstellung von Siliciumformkörpern.**

(30) Priorität: 25.07.84 DE 3427465

(43) Veröffentlichungstag der Anmeldung:
26.02.86 Patentblatt 86/09

(45) Bekanntmachung des Hinweises auf die
Patenterteilung:
17.04.91 Patentblatt 91/16

(84) Benannte Vertragsstaaten:
**AT BE CH DE FR GB IT LI NL SE**

(56) Entgegenhaltungen:
CH-A- 414 955       DE-A- 2 745 247
FR-A- 1 176 125     FR-A- 1 188 576
FR-A- 2 302 132     US-A- 3 601 179

(73) Patentinhaber: **HELIOTRONIC Forschungs-
und Entwicklungsgesellschaft für
Solarzellen-Grundstoffe mbH
Johannes-Hess-Strasse 24
W-8263 Burghausen(DE)**

(72) Erfinder: **Helmreich, Dieter, Dr. Dipl.-Ing.
Robert-Koch-Strasse 185
W-8263 Burghausen(DE)**
Erfinder: **Gessert, Cord, Dr. Dipl.-Ing.
Bachstrasse 12
W-8263 Burghausen(DE)**
Erfinder: **Miller, Hans-Dieter, Dr. Dipl.-Ing.
Fährmannweg 6
W-8261 Stammham(DE)**
Erfinder: **Zauhar, Helmut, Dipl.-Ing.
Zürnstrasse 13
W-8263 Burghausen(DE)**
Erfinder: **Priewasser, Georg
Duttendorf 155
A-5122 Ach(AT)**
Erfinder: **Schmidhammer, Leonhard
Lindenstrasse 8
W-8261 Kirchheim/Tittmoning(DE)**

**Beschreibung**

Die Erfindung betrifft ein Verfahren und eine Vorrichtung zur taktweisen Herstellung von Siliciumformkörpern mit einer Kolumnarstruktur aus einkristallinen Kristallbezirken mit kristallographischer Vorzugsorientierung, bei welchem Gießformen jeweils nacheinander aus einer Beschickungsstation in eine Gießstation eingebracht, mit schmelzflüssigem Silicium befüllt, nach dem gerichteten Erstarren des Siliciums in eine Abkühlstation verbracht und schließlich ausgeschleust werden.

Im Hinblick auf eine gegenüber herkömmlichen Energieträgern konkurrenzfähige Stromerzeugung mit Hilfe der Photovoltaik hat als Solarzellengrundmaterial polykristallines Silicium mit einer Kolumnarstruktur aus einkristallinen Kristallbezirken mit kristallographischer Vorzugsorientierung steigende Bedeutung erlangt. Dieses aus der DE-OS 25 08 803 bekannte Material kann gemäß der DE-OS 27 45 247 durch einen semikontinuierlichen Gießprozeß hergestellt werden.

Bei diesem Verfahren wird in einer Gießstation das schmelzflüssige Silicium in eine einem vertikalen Temperaturgefälle von 200 bis 1000 °C ausgesetzte Form eingegossen und zum Erstarren gebracht. Nach dem vollständigen Erstarren des Siliciums wird die Gießform dann in einer Abkühlstation weitergekühlt und nach dem Erkalten ausgeschleust, während aus einer Beschickungsstation eine weitere Gießform in die Gießstation eingeführt und mit geschmolzenem Silicium befüllt wird. Dieses an sich leistungsfähige Verfahren erfordert jedoch für die Einstellung des Temperaturgefälles der Gießform verhältnismäßig aufwendige Heizvorrichtungen in der Gießstation. Da letztere darüberhinaus während des gesamten Erstarrungsvorganges für weitere Prozeßschritte blockiert ist, kann der Durchsatz bei nach diesem Verfahren betriebenen Anlagen nur bis zu einer bestimmten, durch die Erstarrungsgeschwindigkeit des Siliciums vorgegebenen Rate gesteigert werden.

Aufgabe der Erfindung war es, ausgehend von diesem Stand der Technik, ein Verfahren anzugeben, das das taktweise Gießen von Siliciumformkörpern mit Kolumnarstruktur bei geringerem apparativem Aufwand und erhöhten Durchsatzraten gestattet.

Gelöst wird diese Aufgabe durch ein Verfahren, welches dadurch gekennzeichnet ist, daß die jeweils aus der Beschickungsstation in die Gießstation gelangende Gießform vor dem Eingießen des aufgeschmolzenen Siliciums auf eine Temperatur von 20 bis 1550 °C gebracht wird und nach dem Befüllen mit Silicium vor dessen vollständigem Erstarren in eine Kristallisierstation überführt wird, wo das Silicium durch gerichtete Energieabführung einer gerichteten Erstarrung unterzogen wird, bei welcher seine freie Oberfläche durch Energiezufuhr bis zum Ende des Erstarrungsvorganges zumindest teilweise schmelzflüssig gehalten wird, und daß nach dem vollständigen Erstarren des Siliciums in der Kristallisierstation die Gießform in die Abkühlstation verbracht wird.

Die Vorrichtung zur Durchführung dieses Verfahrens zeichnet sich durch die nachstehenden Merkmale aus: eine vakuumdichte, evakuierbare, einen von einer Heizeinrichtung umgebenen, die Freigabe von Silicium gestattenden Schmelztiegel beherbergende Gießstation mit mindestens einem gegenüber der Außenatmosphäre durch vakuumdichte Absperrorgane getrennten, zum Schmelztiegel führenden Nachchargierkanal und einer die Verbringung einer Gießform in die Gießposition gestattenden Gießformaufnahme, mindestens eine mit der Gießstation verbundene Kristallisierstation mit einer der freien Oberfläche des in der Gießform befindlichen Siliciums Energie zuführenden Energiequelle und einer dieser gegenüberliegenden Energieabführeinrichtung, eine an die Kristallisierstation sich anschließende Abkühlstation, mindestens eine zur Gießstation führende und von ihr durch vakuumdichte Absperrorgane getrennte eine Vorheizstation beinhaltende Beschickungsstation, die Verbringung die Verbringung von Gießformen in die gewünschten Stationen gestattende Transportmittel, sowie Zu- und Ableitungen für Gase.

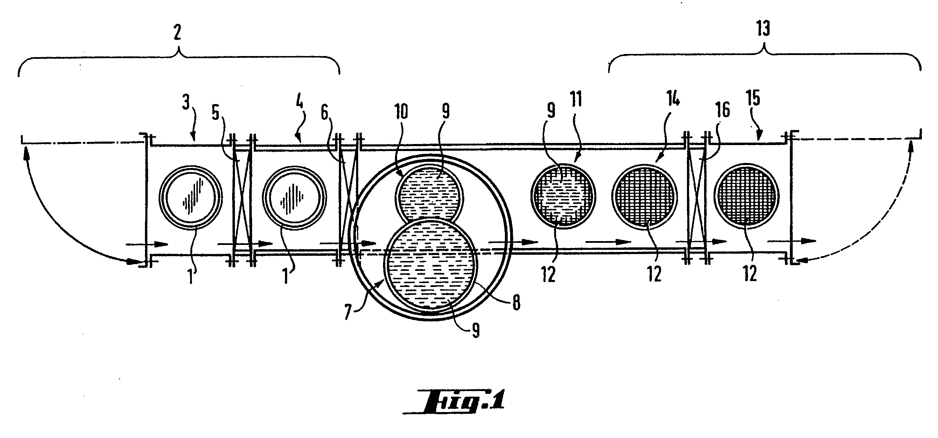

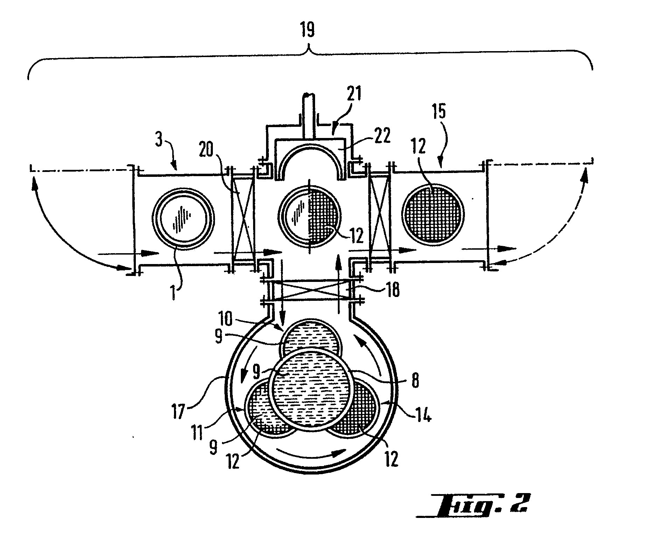

Verfahren und Vorrichtung werden im folgenden anhand der Figuren 1 und 2 näher erläutert; einander entsprechende Funktionen sind in beiden Figuren mit dem selben Bezugzeichen versehen.

Die Figur 1 zeigt schematisch in einer Draufsicht eine mögliche Ausführungsform einer Vorrichtung zur Durchführung des erfindungsgemäßen Verfahrens.

In der Figur 2 wird schematisch eine mögliche andere Ausführungsform einer solchen Vorrichtung angegeben.

Die bei dem Verfahren eingesetzten Gießformen 1, die in den Figuren nur schematisch dargestellt sind, sind grundsätzlich aus der eingangs zitierten Patentliteratur bekannt. Im allgemeinen handelt es sich um aus siliciumresistentem Material, wie beispielsweise Graphit, Siliciumnitrid oder Siliciumcarbid, gefertigte, meist einseitig offene Hohlkörper mit vorzugsweise rechteckigem Innenquerschnitt, deren Dimension sich nach der aufzunehmenden Menge schmelzflüssigen Siliciums richtet. Die Innenmaße werden zweckmäßig so gewählt, daß aus dem erstarrten Silicium, gegebenenfalls nach Abtrennen der Randbereiche, Formkörper mit rechteckigem oder quadratischem Querschnitt von 100 bis 1100, bevorzugt 300 bis 500 mm Kantenlänge erhalten werden; als Höhe des Produktes werden günstig 150 bis 250 mm angestrebt. Bewährt hat es sich auch, die mit Silicium in Kontakt kommenden Flächen der Gießform mit Auskleidungen oder Beschichtungen, z. B. aus Silicium, Siliciumcarbid, Siliciumnitrid, Graphit, Quarz oder anderem geeigneten keramischen Material zu versehen. Mit besonderem Vorteil werden Gießformen eingesetzt, die bei Energiezufuhr durch die Öffnung im wesentlichen eine Energieabgabe durch die der Öffnung gegenüberliegende Begrenzungsfläche gestatten. Günstig besitzen also bei beispielsweise hohlzylinderförmigen Gießformmen die Seitenflächen ein besseres Wärmeisolationsvermögen als die Bodenfläche.

Bei dem erfindungsgemäßen Verfahren wird jede zum Befüllen vorgesehene, leere Gießform 1 in eine Beschickungsstation 2 eingeführt, die zweckmäßig in zwei Unterstationen unterteilt ist, nämlich eine Einbaustation 3 und eine Vorheizstation 4. Die Gießform gelangt zunächst in die Einbaustation 3, wo durch Evakuieren, ggf. auch unter Zusatz von Inertgas oder Inertgasmischungen, ein geeigneter Betriebsdruck, im allgemeinen zwischen $10^{-3}$ und $10^2$ mbar, eingestellt wird, und wird dann in die durch ein Absperrorgan 5, z.B. einen Vakuumschieber, von der Einbaustation 3 getrennte Vorheizstation 4 überführt. Dort wird die Gießform 1 auf die für den Gießvorgang vorgesehene Temperatur gebracht, wobei sie günstig zunächst bei etwa 150 bis 350 °C vorgetrocknet und anschließend zur Entfernung restlicher flüchtiger Verunreinigungen bei etwa 1400 bis 2000 °C, bevorzugt 1500 bis 1600 °C, ausgeheizt wird, und zwar zweckmäßig unter Vakuum oder Inertgas, beispielsweise Wasserstoff, Stickstoff oder Argon. Danach wird die Gießform auf die eigentliche Arbeitstemperatur von 20 bis 1550 °C, vorzugsweise 850 bis 1350 °C, eingestellt. Den unteren Temperaturbereich von 20 bis 850 °C wird man hauptsächlich in den Fällen auswählen, wo eine besonders rasche Abkühlung des eingegossenen Siliciums gewünscht wird und Gießformen aus ausreichend temperaturschockresistentem Material zur Verfügung stehen. Gießformtemperaturen oberhalb 1350 °C, insbesondere oberhalb des Siliciumschmelzpunktes empfehlen sich z. B. dann, wenn das eingegossene Silicium vollständig schmelzflüssig gehalten werden soll, z. B. um eine zusätzliche Reinigung durch Vakuumausdampfung bei 1500 bis 1700 °C (z. B. gemäß DE-OS 29 33 164) oder durch besonders effektive Segregation von Verunreinigungen in Richtung auf die Schmelzenoberfläche während des Kristallisationsvorganges vorzunehmen. In solchen Fällen ist in der Regel der Einsatz von Gießformen erforderlich, die aus besonders widerstandsfähigem Material wie z. B. Siliciumnitrid gefertigt oder zumindest damit ausgekleidet ober beschichtet sind. Für das Vor- und Ausheizen hat sich der Einsatz von, günstig oberhalb der Gießform angeordneten, Strahlungsheizelementen, vorzugsweise aus Graphit oder Siliciumcarbid, bewährt, obwohl grundsätzlich auch andere Methoden der Temperaturerzeugung, z.B. Widerstands- oder induktive Heizung in Frage kommen.

Nach der Vorbehandlung wird die Gießform aus der Beschickungsstation 2 in die durch ein Absperrorgan, z.B. einen Vakuumschieber 6, abgetrennte Gießstation 7 überführt, wobei in beiden Stationen gleiche Druckbedingungen herrschen sollten. In der Gießstation 7 befindet sich, günstig in gegenüber der Gießform erhöhter Position, ein im allgemeinen hohlzylinderförmiger Schmelztiegel 8, welcher gemäß einer bevorzugten Ausführungsform der Erfindung geschwenkt werden kann, um schmelzflüssiges Silicium 9 durch Ausgießen freizugeben. Zweckmäßig wird dieser, aus siliciumresistentem Material, vorzugsweise.Quarz, gefertigte Schmelztiegel direkt mit Hilfe von im Innern der Gießstation 7 vorgesehenen Heizeinrichtungen beheizt, und zwar günstig induktiv vermittels eines ihn umgebenden zweiten Heiztiegels aus elektrisch leitendem Material, vorzugsweise Graphit, der ebenfalls schwenkbar ist und seinerseits innerhalb einer oder mehrerer Induktionsspulen angeordnet ist. Zwischen Heiztiegel und Spule(n) werden vorteilhaft eine oder mehrere elektrisch isolierende und wärmedämmende Schichten von etwa 10 bis 200 mm Dicke eingebracht, um die Wärmeverluste gering zu halten. Gegebenenfalls kann der Schmelztiegel zusätzlich von oben und/oder unten wärmeisoliert bzw. beheizt werden, und zwar günstig mit Hilfe von beim Nachchargieren oder Gießen entfernbaren, schwenkbaren Wärmedämmschichten bzw. Strahlungsheizern aus beispielsweise entsprechend erhitzten Graphit- oder Siliciumcarbidplatten.

Um das bisweilen erforderliche Auswechseln verbrauchter Schmelztiegel zu erleichtern, hat es sich bewährt, den Heiztiegel mit sich leicht konisch von unten nach oben erweiternden Seitenwänden sowie einem vertikal beweglichen Boden zu versehen. Zweckmäßig wird in der Außenwandung des Rezipienten eine eigene vakuumdichte Zugangsmoglichkeit für den Ein- und Ausbau der Schmelztiegel vorgesehen.

Das einzubringende Silicium wird, gewöhnlich in körniger bis stückiger Form (mittlere Korngröße typisch etwa 1 bis 150 mm), über einen Nachchargierkanal in den Schmelztiegel eingetragen. Der im allgemeinen rinnenförmig ausgebildete Nachchargierkanal führt von einer Schleuse, über welche das Schmelzgut von außen in die Gießstation eingebracht werden kann, zu einer zum Befüllen des Schmelztiegels geeigneten Position oberhalb von dessen Öffnung. Gegebenenfalls kann der Nachchargierkanal auch als Schüttelrinne ausgebildet oder beweglich sein, so daß er aus einer während des Befüllens eingenommenen Arbeitsposition während des Aufschmelzvorganges in eine Ruheposition gebracht werden kann. Er kann auch über Transportelemente verfügen, die außerhalb der Gießstation beladen werden und über die Schleuse das Nachchargiergut zum Schmelztiegel bringen und dort freigeben.

In diesem Zusammenhang hat es sich bewährt, den Schmelztiegel nicht in einem Schritt, sondern nach und nach portionsweise zu befüllen. Dadurch lassen sich einerseits die Dimensionen des Nachchargierkanals gering halten, während gleichzeitig ein höherer Füllungsgrad des Schmelztiegels zu erzielen ist.

Grundsätzlich ist es auch möglich, das Silicium in schmelzflüssiger Form in den Schmelztiegel zuzuchargieren, und zwar beispielsweise dann, wenn es aus vorhergehenden Reinigungsprozessen, z. B. gemäß DE-OS 29 33 164 oder DE-OS 27 29 464, bereits als Schmelze zur Verfügung steht. In derartigen Fällen kann auch vorgesehen sein, die Gießformen direkt, d. h. ohne Zwischenschalten eines Schmelztiegels, zu befüllen.

Beim Nachchargieren von festem Silicium wird der Schmelztiegel zweckmäßig auf Temperaturen von 150° C bis 1600° C gehalten. Bei Quarzschmelztiegeln werden vorzugsweise 700 bis 1500° C gewählt, da das Material in diesem Intervall erfahrungsgemäß gegenüber mechanischen Beanspruchungen verhältnismäßig günstige Eigenschaften besitzt. Wird in eine bereits vorhandene Schmelze bzw. geschmolzenes Silicium nachchargiert, hat es sich zudem als vorteilhaft erwiesen, die Chargenmenge und die Tiegeltemperatur so abzustimmen, daß ein Wiedererstarren des gesamten Tiegelinhaltes vermieden wird, da ansonsten wegen der Volumenvergrößerung des Siliciums beim Erstarren die Tiegelwandung großen mechanischen Belastungen ausgesetzt ist. Nötigenfalls können beim Nachchargieren auch Dotierstoffe zugesetzt werden.

In der Regel wird während des Aufschmelzvorganges in der Gießstation ein Druck von 0,1 bis 100 mbar, vorzugsweise 1 bis 20 mbar, eingestellt. Günstig ist dabei auch die Zufuhr von Inertgas,und zwar insbesondere von oben in Richtung auf die Schmelzenoberfläche.

Wenn bzw. kurz bevor das Material im Schmelztiegel in vollständig geschmolzener Form vorliegt, wird aus der Beschickungsstation 2 eine Gießform 1 in die Gießstation 7 überführt und dort in die Gießformaufnahme 10 gebracht, um dann mit dem schmelzflüssigen Silicium befüllt zu werden. Um eine allzu lange Gießstrecke zu vermeiden, wird im allgemeinen die Gießformder Stelle angenähert, wo das geschmolzene Silicium 9 den Schmelztiegel 8 verläßt. Zu diesem Zweck kann beispielsweise eine eine geeignete Auflagefläche aufweisende, ausfahrbare, vorteilhaft drehbare, Welle vorgesehen sein, mit deren Hilfe die Gießform nach oben gehoben oder abgesenkt werden kann. In den meisten Fällen kann dadurch beim Gießvorgang auf zusätzliche Hilfsmittel, wie z. B. Trichter oder Rinnen, verzichtet werden.

Während des Gießens werden die Gießformen vorteilhaft um ihre zentrale Längsachse gedreht, und zwar zweckmäßig mit etwa 10 bis 60 Umdrehungen pro Minute. Auf diese Weise kann ihre thermische und mechanische Belastung verringert werden. Zugleich bildet sich innerhalb kurzer Zeit an der Kontaktfläche zwischen Gießformwandung und Siliciumschmelze eine Schicht erstarrten Siliciums 12, so daß das restliche schmelzflüssige Silicium 9 in der Gießform gleichsam von einem Tiegel aus festem Silicium umgeben ist. Dies trägt insbesondere dazu bei, die Gefahr der Bildung von Verunreinigungen durch Reaktion zwischen Tiegelwandung und Siliciumschmelze gering zu halten.

Beim Eingießen kann eine Überhitzung der Gießform durch die heiße Schmelze dadurch verhindert werden, daß nach dem Eis-Würfel-Prinzip sogenannte Opferstücke aus Silicium, beispielsweise als Auskleidung der Gießform, vorgelegt werden, welche selbst zum Schmelzen gebracht werden und so der Schmelze Wärme entziehen.

Nach beendetem Eingießen und vor dem vollständigen Erstarren des schmelzflüssigen Siliciums wird die Gießform aus der Gießformaufnahme 10 entfernt und in die Kristallisierstation 11 überführt. Der beste Zeitpunkt hierfür ist dann erreicht, wenn sich auf der Schmelzenoberfläche aufgrund der hohen Wärmeabstrahlung ein geschlossener Deckel aus erstarrtem Silicium gebildet hat, der ein Überschwappen der Schmelze während des Transportes verhindert und zugleich Verunreinigungen fernhält.

In der Kristallisierstation 11 wird dieser Eigenmaterialdeckel zumindest teilweise wieder aufgeschmolzen; ein vollständiges Wiederaufschmelzen des bereits erstarrten Siliciums 12 ist in den meisten Fällen nicht notwendig. Als Energiequelle wird günstig eine Strahlungsheizquelle, z.B. in Form von Graphit- oder Siliciumcarbidheizelementen, eingesetzt, welche oberhalb der Öffnung der Gießform angeordnet ist und die Energie auf die freie Oberfläche des Siliciums einstrahlt. Selbstverständlich können zur Beheizung der Oberfläche auch andere Heiztechniken, z.B. Widerstands- oder Induktionsheizung, herangezogen werden. Die Heizelemente werden günstig auf Temperaturen oberhalb des Siliciumschmelzpunktes bis etwa 1600° C , bevorzugt 1430 bis 1480° C gehalten. Zur Erzeugung eines nahezu vertikal gerichteten Energieflusses - letztendlich also Temperaturgradienten - wird der der Energiequelle gegenüberliegenden Fläche der Gießform, der Bodenfläche, Gelegenheit zur Energieabgabe gegeben. Dies kann beispielsweise durch Wärmeabstrahlung oder Wärmeaustausch geschehen, z.B. durch eine mit dem Boden der Gießform in Kontakt gebrachte, von flüssigem oder gasförmigem Kühlmedium durchströmte Wärmetauscherfläche, z. B. aus Graphit, Kupfer oder Eisen. Die Energieabführung durch die Kühlung, z. B. vermittels Kühlwasser, wird günstig mit der Energiezufuhr so abgestimmt, daß eine Kristallisationsgeschwindigkeit von 0,1 bis 5 mm/min, vorzugsweise 1 bis 2 mm/min, erreicht wird. Wie bereits ausgeführt, kann durch Wärmeisolation der Seitenteile der Gießform die Ausbildung einer nahezu horizontalen Kristallisationsfront unterstützt werden.

Während der Kristallisation wird die freie Oberfläche des Siliciums mit Hilfe der Heizkörper zumindest teilweise schmelzflüssig gehalten, bis der größte Teil, d.h. etwa 80 bis 95 %, des gesamten Siliciums erstarrt ist. Danach wird die Temperatur der Heizelemente allmählich verringert, günstig mit einer Rate von 0,1 bis 10 °C/min, und somit auch das Silicium an der freien Oberfläche der Gießform nach und nach zum Erstarren gebracht. Durch diese Verfahrensweise wird verhindert, daß beim Erstarrungsvorgang schmelzflüssiges Silicium von erstarrtem Silicium eingeschlossen wird und, wegen der Volumenvergrößerung beim Erstarren, thermisch induzierte Spannungen, Risse, oder andere mechanische Beschädigungen im Produkt und/oder der Gießform verursacht. Die Kristallisation kann auch dadurch günstig beeinflußt werden, daß die Gießform um ihre vertikale Achse in Drehung versetzt wird.

Während der Kristallisation wird in der Kristallisierstation eine Vakuum- oder Inertgasatmosphäre, günstig von etwa 5 bis 100 mbar, aufrechterhalten. Insbesondere hat es sich bewährt, dabei einen Inertgasstrom über die Schmelzenoberfläche zu führen, von dem etwa auftretende gasförmige Verunreinigungen wie Silicium- oder Kohlenmonoxid abtransportiert werden können.

Nach dem vollständigen Erstarren wird das Silicium einem Tempervorgang unterworfen, welcher etwaige Spannungen im Material abbaut und zugleich die Temperaturverteilung homogenisiert. Grundsätzlich kann dieser Schritt auch in der Kristallisierstation 11 durchgeführt werden. Günstiger wird jedoch die Gießform in eine sich an die Kristallisierstation 11 anschließende Abkühlstation 13 überführt. Zweckmäßig wird diese in zwei Unterstationen, eine Temperstation 14 und eine Schnellkühlstation 15, unterteilt. Die Gießform gelangt zunächst in die Temperstation 14, bei welcher ein Absperrorgan gegenüber der Kristallisierstation 11 in der Regel nicht erforderlich ist. Dort wird, vorzugsweise mit einer Abkühlgeschwindigkeit von 0,5 bis 30 °C/min, das erstarrte Silicium 12 auf eine Temperatur von 900 bis 1300 °C heruntergetempert. In der Regel wird dabei das Silicium in der Gießform vom Boden her nicht mehr gekühlt, während die Energieeinstrahlung auf seine freie Oberfläche um etwa 10 bis 50 % des Wertes reduziert wird, der in der Kristallisierstation zur Einwirkung kam. Die Energie wird, ähnlich wie in der Kristallisierstation, über geeignete Heizquellen, wie Widerstands- oder Induktionsheizung, bevorzugt aber über Strahlungsheizer, beispielsweise aus Graphit- oder Siliciumcarbidheizelementen, zugeführt.

Nach Erreichen der geforderten Temperatur - die Temperaturüberwachung erfolgt in der gesamten Vorrichtung bevorzugt über berührungslos arbeitende Temperaturmeßgeräte, z.B. Pyrometer - wird die Gießform in eine von der Temperstation 14 durch ein vakuumdichtes Absperrorgan 16 abgetrennte Schnellkühlstation 15 weitergeleitet. Dort wird das erstarrte Silicium auf Druck- und Temperaturbedingungen gebracht, bei welchen es schließlich aus dieser Station ausgeschleust werden kann. Für die Entnahme hat sich eine Temperatur von weniger als 700 °C als geeignet erwiesen, zum einen, da das Silicium dann außerhalb des Temperaturbereichs von 700 bis 900 °C liegt, in dem es noch plastisch verformbar ist, zum anderen, da dann auch die Gefahr des Abbrandes von aus Graphit gefertigten Hilfsmitteln, z.B. der Gießform, beim Zutritt oxidierender Gase, z. B. Luft, gering ist. Die Kühlung erfolgt zweckmäßig über einen die Gießform überstreichenden, gegebenenfalls im Rezipienten umgewälzten und extern gekühlten Strom aus nicht oxidierenden Gasen, insbesondere Stickstoff oder Argon. Zusätzlich kann die Kühlwirkung durch mit dem Boden der Gießform in Kontakt befindliche, von Kühlmittel durchströmte Wärmetauscherflächen gesteigert werden. Bei Beginn der Schnellkühlung kann der Druck in der Schnellkühlstation, der beim Einbringen der getemperten Gießform zweckmäßig in etwa auf den Wert der Temperstation eingestellt war, auf Atmosphärendruck gesteigert werden. Grundsätzlich kann der Temper- und Schnellkühlschritt auch in einer einzigen Station durchgeführt werden, wobei dann allerdings ein vakuumdichtes Absperrorgan zur Kristallisierstation unerläßlich ist. Nach Erreichen der Grenztemperatur von 700 °C kann die Schnellkühlstation belüftet werden. Gemäß der in Figur 2 schematisch dargestellten, möglichen Ausführungsform können in einer Vorrichtung zur Durchführung des erfindungsgemäßen Verfahrens auch der Schmelztiegel 8 mit Schwenk- und Nachchargiereinheit, sowie zweckmäßig in einer darunterliegenden Ebene drehscheibenartig angeordnet, die Gießformaufnahme 10, die Kristallisierstation 11 und die Temperstation 14 innerhalb eines einzigen Gießturms 17 zusammengefaßt sein, wobei die einzelnen Stationen für sich analog zu der Funktionsbeschreibung zur Figur 1 aufgebaut sind. Der Gießturm 17 ist über eine Ein- und Ausführschleuse 18 mit einer Be- und Entladestraße 19 verbunden, bei welcher die Gießformen 1 zunächst in die Einbaustation 3 und dann in die durch ein vakuumdichtes Absperrorgan 20 abgetrennte Verschiebestation 21 gelangen. Von dort aus können einerseits leere Gießformen in den Gießturm 17 eingeführt und andererseits aus dem Gießturm ausgeschleuste, mit erstarrtem Silicium befüllte Gießform in die Schnellkühlstation 15 weitergeleitet werden. Für leere Gießformen erfüllt die Verschiebestation 21 dabei die Aufgaben der Vorheizstation (entsprechend Figur 1), d. h. Ausheizen sowie Einstellung von Arbeitstemperatur und -druck. Volle Gießformen werden hingegen meist möglichst rasch in die Schnellkühlstation weitergeleitet, um die Verschiebestation nicht für die nächste auszuheizende leere Gießform zu blockieren.

Die Ein- bzw. Ausfuhr der Gießformen zum bzw. vom Gießturm 17 läßt sich beispielsweise mit Hilfe von horizontal beweglichen Schiebegabeln 22 bewerkstelligen. Dort gelangt die eingeführte leere Gießform in die Gießformaufnahme 10 und wird analog zu der in Figur 1 beschriebenen Vorgehensweise in der Regel mittels einer ausfahrbaren, drehbaren Welle nach oben an die Stelle herangeführt, wo das geschmolzene Silicium 9 den Schmelztiegel 8 verläßt. Nach dem Befüllen wird die Gießform in die Ausgangsstellung zurückgefahren und in die nächste Drehscheibenposition, die Kristallisierstation, weitergeleitet, wo das Silicium gerichtet erstarrt. Die gegebenenfallsvon dem vorhergehenden Gießvorgang dort befindliche, mit bereits vollständig erstarrtem Silicium 12 gefüllte Gießform wird gleichzeitig durch die Drehung in die Temperstation 14 überführt, wahrend die dort gegebenenfalls vorhandene, auf 900 bis 1300°C getempertes Silicium enthaltende Gießform zur Gießformaufnahme 10 gelangt und von dort in die Verschiebestation 21 und nachfolgend in die Schnellkühlstation 15 ausgeschleust wird. Anschließend kann eine neue, leere, entsprechend vorbereitete Gießform nach Durchlaufen der Verschiebestation 21 die freie Gießformaufnahme 10 im Gießturm neu besetzen.

Selbstverständlich lassen sich die in den Figuren 1 und 2 dargestellten Vorrichtungen zur Durchführung des erfindungsgemäßen Verfahren in vielerlei Hinsicht modifizieren, ohne den Erfindungsgedanken zu verlassen. Dies gilt insbesondere für solche Vorrichtungen, bei denen für den bzw. die jeweils zeitaufwendigsten und damit geschwindigkeitsbestimmenden Verfahrensteilschritte mehrere parallel oder nacheinandergeschaltet arbeitende Stationen vorgesehen sind. So sind z. B. auch Varianten mit mehreren Beschickungs-, Gieß-, Kristallisier-, Temper- oder Schnellkühlstationen denkbar. In diesem Zusammenhang wirkt sich die Tatsache günstig aus, daß Gieß- und Kristalliervorgang nicht streng aneinander gekoppelt sind.

Ein besonderer Vorteil des Verfahrens liegt darin, daß es die gleichzeitige Belegung aller Stationen mit Gießformen und die parallele Durchführung der einzelnen Verfahrensteilschritte gestattet. Eine bevorzugte Ausführungsform der Erfindung beinhaltet die folgenden, gleichzeitig ablaufenden Maßnahmen: während in den Schmelztiegel chargiertes, festes Silicium zum Schmelzen gebracht wird, wird in die Einbaustation eine neue Gießform eingebracht und eine weitere in der Vorheizstation ausgeheizt. Gleichzeitig befinden sich in der Kristallisierstation eine Gießform mit erstarrendem Silicium, in der Temperstation eine Gießform, deren Inhalt auf etwa 900 bis 1300°C heruntergetempert wird und in der Schnellkühlstation eine weitere Gießform mit getempertem Silicium, das auf die Entnahmebedingungen gebracht wird. Wenn diese letzte Gießform die Apparatur verlassen hat, können alle Gießformen ihre bisherige Position freimachen und in die jeweils nächste Station verlegt werden. Die ausgeheizte Gießform wird aus der Vorheizstation in die Gießformaufnahme gebracht, mit inzwischen aufgeschmolzenem Silicium befüllt, und gelangt dann in die Kristallisierstation, die vorher von der in die Temperstation überführten Gießform besetzt war. Während der Kristallisation wird im Schmelztiegel neues Silicium erschmolzen, wobei die Gießformaufnahme bei der Figur 2 entsprechenden Anordnungen frei bleiben muß, während sie bei solchen gemäß Figur 1 besetzt werden kann. Grundsätzlich kann jedoch auf diese bevorzugte gleichzeitige Belegung der Stationen auch verzichtet werden.

Für die Überführung der Gießformen in die jeweils vorgesehenen Stationen kommen die für diesen Zweck bekannten und dem Fachmann geläufigen Transportmittel in Frage. Möglich ist beispielsweise der Einsatz von Transportschlitten, Schiebegabeln, oder in manchen Fällen auch von drehbaren Plattformen. Eine elegante Lösung ist die Verwendung von Straßen aus getrennt regelbaren Rollen, die bei Bedarf in Gang gesetzt werden und die gewünschte Bewegung der jeweils ausgewählten Gießform bewirken. Demgegenüber weniger günstig ist der Einsatz von Förderbändern, da er eine streng synchrone Prozeßführung erfordert.

Die nach dem Verfahren erhaltenen Siliciumblöcke besitzen eine Kolumnarstruktur aus einkristallinen Kristallbezirken mit kristallographischer Vorzugsorientierung, wobei im allgemeinen mittlere Korngrößen von 0,3 bis 100 mm, typisch 1 bin 30 mm, erreicht werden können. Die Blöcke stellen nach Abtrennen der Randbereiche ein ausgezeichnetes Solarzellengrundmaterialdar, mit welchem sich bereits Wirkungsgrade von 10 bis 17 % erzielen ließen.

Ausführungsbeispiel:

In einer der Fig. 2 entsprechenden Anlage wurde ein in einem Gießturm mit wassergekühlter Edelstahlwandung befindlicher, schwenkbarer, induktionsbeheizter Quarz-Schmelztiegel (Höhe ca. 600 mm, Durchmesser ca. 500 mm, Wandstärke ca. 8 mm) über einem mit einem kippbaren Schaufelmechanismus ausgestatteten Nachchargierkanal nach und nach portionsweise (jeweils etwa 5 bis 20 kg) mit grobstückigem Silicium (Teilchengröße ca. 5 - 150 mm) nahezu vollständig befüllt. Nach dem teilweisen Aufschmelzen dieser Charge wurden jeweils neue Portionen Silicium (jeweils 5 - 20 kg) zuchargiert, bis insgesamt etwa 100 kg Silicium aufgeschmolzen waren. Während des Schmelzvorganges wurde der Tiegel in einem Temperaturbereich von ca. 1420 bis 1480° C gehalten, und schließlich eine Schmelzentemperatur (Messung über Pyrometer) von 1430° C eingestellt. Im Rezipienten, durch den von oben nach unten ein Argonstrom geleitet wurde, lag ein Druck von 10 mbar vor.

Zur selben Zeit wurde als Gießform ein Graphithohlzylinder mit quadratischem Innenquerschnitt (Innenhöhe ca. 280 mm, Innenkantenlänge ca. 430 mm, Außendurchmesser ca. 750 mm einschließlich Wärmeisolierung der Seitenwände), dessen Innenraum mit ca. 6 mm dicken Platten aus grobkristallinem Reinstsilicium ausgekleidet war, in die über eine vakuumdichte Klappe von der Außenatmosphäre abgetrennte Einbaustation der Be- und Entladestraße geschoben. Nach Evakuieren und Einstellen des Betriebsdruckes (ca. $10^{-1}$ bis $10^{-3}$ mbar) wurde die Gießform mittels eines Transportschlittens in die über einen wassergekühlten Vakuumschieber abgetrennte, bereits evakuierte Verschiebestation der Be- und Entladestraße weitergeführt.

Dort wurde die Gießform mit Hilfe einer oberhalb von ihr angeordneten und entsprechend ihrem Querschnitt geformten, beheizten Graphitstrahlungsheizplatte für ca. 60 min. auf etwa 250° C gehalten und vakuumgetrocknet. Danach wurde die Temperatur des Heizelementes auf ca. 1500° C erhöht und die Gießform für weitere 30 min. ausgeheizt. Anschließend wurde die Temperatur der Gießform auf etwa 1100° C heruntergefahren und ein Argondruck von etwa 10 mbar, entsprechend dem im Gießturm vorliegenden Wert, eingestellt.

Unterdessen war das in den Schmelztiegel chargierte Silicium vollständig aufgeschmolzen. Nun wurde die Gießform mittels einer Schiebegabel aus der Verschiebestation in die Gießformaufnahme des Gießturms weitergeleitet. Diese, ein mit einer wassergekühlten, ausfahrbaren, drehbaren Welle verbundener mit zusätzlicher Wärmeisolierung versehener Graphitteller wurde nach oben gefahren, bis die vorgesehene Gießposition erreicht war. Nun wurde der Schmelztiegel gekippt, und das schmelzflüssige Silicium ergoß sich in die mit etwa 10 U/min. gedrehte Gießform.

Nach deren vollständigem Befüllen wurde der Schmelztiegel in die Ausgangsposition zurückgekippt und konnte erneut mit festem Silicium beladen werden. Die Gießform wurde unter fortgesetztem Drehen aus der Gießposition zurückgefahren und in der Gießformaufnahme belassen, bis sich die Oberfläche des eingegossenen Siliciums mit einer dünnen Schicht erstarrtem Siliciums überzogen hatte. Nun wurde die Gießform mit Hilfe der Drehscheibe in die Kristallisierstation überführt.

Dort wurde von oben die freie Oberfläche des Siliciums mittels eines Graphitstrahlungsheizers (Temperatur etwa 1440° C) erneut annähernd vollständig aufgeschmolzen, während der Boden der Gießform durch eine wassergekühlte Kupferplatte gekühlt wurde. Bei einer Kristallisationsgeschwindigkeit von etwa 1,0 mm/min. war die etwa 215 mm hohe Siliciumschmelze nach etwa 240 min. vollständig durchkristallisiert. Gegen Ende des Kristallisationsvorganges, d. h. nach Erstarren von etwa 90 % des vorhandenen Siliciums wurde die Temperatur des Strahlungsheizers um ca. 0,5°/min. heruntergefahren, bis auch die freie Siliciumoberfläche zum Erstarren kam. Während der Kristallisation wurde die Gießform mit ca. 10 U/min, in der Endphase mit ca. 1 U/min. gedreht. Zugleich wurde einer leichter Argonstrom über die Oberfläche des Siliciums geführt.

Die Gießform mit dem vollständig erstarrten Silicium wurde sodann mit Hilfe der Drehscheibe in die Temperstation weiter transportiert und dort ohne weitere Kühlung des Bodens belassen. Der knapp oberhalb der Gießformöffnung installierte Strahlungsheizer wurde von dem anfangs eingestellten, der Endtemperatur in der Kristallisierstation entsprechenden Wert mit etwa 2,5°/min. bis auf 1260° C heruntergefahren und dann ganz abgestellt. Nach ca. 90 min. war die Temperatur in der Gießform auf etwa 950° C abgesunken und die Temperaturverteilung weitgehend homogenisiert.

Nun konnte die Gießform aus dem Gießturm ausgeschleust werden. Zu diesem Zweck wurde sie zunächst mit Hilfe der Drehscheibe in die Gießformaufnahme überführt und von dort aus mittels Schiebegabel in die Verschiebestation transportiert, um von dort aus mit Hilfe eines Transportschlittens unmittelbar in die Schnellkühlstation der Be- und Entladestraße weitergeleitet zu werden. Diese wurde nunmehr mit Argon geflutet und auf Atmosphärendruck eingestellt, wobei anschließend die Argonatmosphäre ständig umgewälzt und über externe Wärmetauscher gekühlt wurde. Dadurch konnte innerhalb von etwa 150 min. die Temperatur auf unter 700° C abgesenkt werden. Nun wurden die Kühleinrichtungen abgestellt und die Schnellkühlstation geöffnet. Die Gießform wurde ausgeschleust und schließlich bis zur Entnahme des Siliciumblocks an Luft weiter abgekühlt.

Danach wurde der erhaltene Block in Einzelblöcke von 10 x 10 cm Querschnitt zersägt, welche dann in die als eigentliches Ausgangsmaterial für Solarzellen dienenden Scheiben zertrennt wurden. Die daraus erhaltenen Solarzellen hatten Wirkungsgrade im Bereich von 10 - 13 % .

Durch gleichzeitige Belegung von Einbaustation, Verschiebestation (als Vorheizstation), Kristallisierstation, Temperstation und Schnellkühlstation mit leeren bzw. gefüllten Gießformen sowie gleichzeitiges Aufschmelzen von Silicium im Schmelztiegel konnte der Prozeß so geführt werden, daß sich im Vierstundentakt jeweils eine einen fertigen Siliciumblock enthaltende Gießform der Apparatur entnehmen ließ. Dabei wurden die Verweilzeiten in den einzelnen Stationen an den jeweils zeitaufwendigsten Einzelschritt, in der Regel den Schmelz- bzw. Kristallisationsvorgang, angepaßt.

## Ansprüche

1. Verfahren zur taktweisen Herstellung von Siliciumformkörpern mit einer Kolumnarstruktur aus einkristallinen Kristallbezirken mit kristallographischer Vorzugsorientierung, bei welchem Gießformen jeweils aufeinanderfolgend aus einer Beschickungsstation in eine Gießstation eingebracht, mit aufgeschmolzenem Silicium befüllt, nach dem gerichteten Erstarren des Siliciums in eine Abkühlstation verbracht und schließlich ausgeschleust werden, **dadurch gekennzeichnet,** daß die jeweils aus der Beschickungsstation in die Gießstation gelangende Gießform vor dem Eingießen des aufgeschmolzenen Siliciums auf eine Temperatur von 20 bis 1550 °C gebracht wird und nach dem Befüllen mit Silicium vor dessen vollständigem Erstarren in eine Kristallisierstation überführt wird, wo das Silicium durch gerichtete Energieabgabe einer gerichteten Erstarrung unterzogen wird, bei welcher seine freie Oberfläche durch Energiezufuhr bis zum Ende des Erstarrungsvorganges zumindest teilweise schmelzflüssig gehalten wird, und daß nach dem vollständigen Erstarren des Siliciums in der Kristallisierstation die Gießform in die Abkühlstation verbracht wird.

2. Verfahren nach Anspruch 1, **dadurch gekennzeichnet,** daß Beschickungsstation, Kristallisierstation und Abkühlstation gleichzeitig mit Gießformen besetzt werden.

3. Verfahren nach den Ansprüchen 1 und 2, **dadurch gekennzeichnet,** daß bei der gerichteten Erstarrung des Siliciums eine Kristallisationsgeschwindigkeit von 0,1 bis 5 mm/min eingehalten wird.

4. Verfahren nach einem oder mehreren der Ansprüche 1 bis 3, **dadurch gekennzeichnet,** daß in der Kristallisierstation die Gießform mit dem erstarrenden Silicium gedreht wird.

5. Verfahren nach einem oder mehreren der Ansprüche 1 bis 4, **dadurch gekennzeichnet,** daß das erstarrte Silicium mit einer Abkühlrate von 0,5 bis 30 °C/ min auf 900 bis 1300 °C getempert, dann rasch auf eine Temperatur unterhalb 700 °C gekühlt und anschließend ausgeschleust wird.

6. Vorrichtung zur Durchführung des Verfahrens nach den Ansprüchen 1 bis 5 mit einer vakuumdichten, evakuierbaren, einen von einer Heizeinrichtung umgebenen, die Freigabe von Silicium gestattenden Schmelztiegel beherbergenden Gießstation mit mindestens einem gegenüber der Außenatmosphäre durch Schleusen getrennten, zum Schmelztiegel führenden Nachchargierkanal, und einer die Verbringung einer Gießform in die Gießposition gestattenden Gießformaufnahme, mindestens einer mit der Gießstation verbundenen Kristallisierstation mit einer der freien Oberfläche des in der Gießform befindlichen Siliciums Energie zuführenden Energiequelle und einer dieser gegenüberliegenden Energieabführeinrichtung, einer an die Kristallisierstation sich anschließenden Abkühlstation, mindestens einer zur Gießstation führenden und von ihr durch vakuumdichte Absperrorgane getrennte eine Vorheizstation beinhaltenden, Beschickungsstation, die Verbringung von Gießformen in die gewünschten Stationen gestattenden Transportmitteln sowie Zu- und Ableitungen für Gase.

7. Vorrichtung nach Anspruch 6, **dadurch gekennzeichnet,** daß die Beschickungsstation in Einbaustation und Vorheizstation unterteilt ist.

8. Vorrichtung nach den Ansprüchen 6 oder 7, **dadurch gekennzeichnet,** daß die Abkühlstation in Temperstation und Schnellkühlstation unterteilt ist.

9. Vorrichtung nach einem oder mehreren der Ansprüche 6 bis 8, **dadurch gekennzeichnet,** daß der Schmelztiegel sowie in einer darunterliegenden Ebene drehscheibenartig Gießformaufnahme, Kristallisierstation und Temperstation innerhalb eines über eine Verschiebestation mit einer Be- und Entladestraße verbundenen Gießturms angeordnet sind.

**10.** Vorrichtung nach einem oder mehreren der Ansprüche 6 bis 9, **dadurch gekennzeichnet,** daß für den jeweils zeitaufwendigsten Verfahrensteilschritt mehrere parallel oder nacheinander geschaltet arbeitende Stationen vorgesehen werden.

## Claims

**1.** Process for cyclically producing silicon moulded bodies having a column structure and made up of monocrystalline crystal regions with crystallographic preferred orientation, in which process casting moulds are each introduced sequentially from a loading station into a casting station, filled with molten silicon, transferred to a cooling station after the directional solidification of the silicon and, finally discharged, characterized in that the casting mould entering the casting station from the loading station in each case is brought to a temperature of 20 to 1,550 °C before the molten silicon is poured in and after filling with silicon is transferred to a crystallization station before the silicon completely solidifies, in which crystallization station the silicon is subjected, by directional removal of energy, to a directional soldification in which its free surface is kept at least partially molten by supplying energy until the end of the solidifaction process, and in that after the silicon has completely solidified in the crystallization station, the casting mould is transferred to the cooling station.

**2.** Process according to Claim 1, characterized in that the loading station, crystallization station and cooling station are simultaneously occupied by casting moulds.

**3.** Process according to Claims 1 and 2, characterized in that a crystallization rate of 0.1 to 5 mm/min is maintained during the directional solidification of the silicon.

**4.** Process according to one or more of Claims 1 to 3, characterized in that the casting mould containing the solidifying silicon is rotated in the crystallization station.

**5.** Process according to one or more of Claims 1 to 4, characterized in that the solidified silicon is annealed at a cooling rate of 0.5 to 30 °C/min at 900 to 1,300 °C, and is then rapidly cooled to a temperature below 700 °C and subsequently discharged.

**6.** Apparatus for carrying out the process according to Claims 1 to 5, having a vacuum tight, evacuable casting station which accommodates a melting crucible surrounded by a heating device and making possible the release of silicon and which has at least one recharging channel which is separated with respect to the outside atmosphere by locks and leads to the melting crucible, and a casting mould receptacle which makes possible the transfer of a casting mould to the casting position, at least one crystallization station which is connected to the casting station and has an energy source supplying energy to the free surface of the silicon in the casting mould and an energy removal device situated opposite the energy source, a cooling station adjacent to the crystallization station, at least one loading station which leads to the casting station and is separated from it by vacuum tight shut-off devices and which incorporates a preheating station, transport means which make possible the transfer of casting moulds to the required stations and also inlet and outlet pipes for gases.

**7.** Apparatus according to Claim 6, characterized in that the loading station is subdivided into insertion station and preheating station.

**8.** Apparatus according to Claims 6 or 7, characterized in that the cooling station is subdivided into annealing station and rapid cooling station.

**9.** Apparatus according to one or more of Claims 6 to 8, characterized in that the melting crucible and also casting mould receptacle situated in turntable fashion in a plane underneath it, crystallization station and annealing station are disposed inside a casting tower connected to a loading and unloading track via a transfer station.

**10.** Apparatus according to one or more of Claims 6 to 9, characterized in that a plurality of stations operating in parallel or in sequence are provided for the most time-consuming process substep in a particular case.

## Revendications

**1.** Procédé pour fabriquer de façon cadencée des corps moulés en silicium possédant une structure en colonne et formés de domaines monocristallins possédant une orientation cristallographique préférentielle, et selon lequel on insère respectivement des moules de coulée successivement depuis un poste de chargement dans un poste de coulée et on les remplit avec du silicium fondu et, après la solidification orientée du silicium, on les place dans un poste de refroidissement et enfin on les extrait par un sas, caractérisé en ce que le moule de coulée, qui parvient respectivement du poste de chargement dans le poste de coulée, est amené à une température comprise entre 20 et 1550°C avant la coulée du silicium fondu, et est transféré, après le remplissage avec du silicium et avant la solidification complète de ce dernier, dans un poste de cristallisation, dans lequel le silicium est soumis, au moyen d'une évacuation dirigée d'énergie, à une solidification dirigée, lors de laquelle sa surface libre est maintenue au moins partiellement à l'état fondu liquide au moyen d'un apport d'énergie jusqu'à la fin de l'opération de solidification, et qu'après la solidification complète du silicium dans le poste de cristallisation, le moule de coulée est amené dans le poste de refroidissement.

2. Procédé selon la revendication 1, caractérisé en ce que le poste de chargement, le poste de cristallisation et le poste de refroidissement sont occupés simultanément par des moules de coulée.

3. Procédé selon les revendications 1 et 2, caractérisé en ce que, lors de la solidification dirigée du silicium, une vitesse de cristallisation comprise entre 0,1 et 5 mm/mn est respectée.

4. Procédé selon une ou plusieurs des revendications 1 à 3, caractérisé en ce que, dans le poste de cristallisation, le moule de coulée contenant le silicium en cours de solidification est entraîné en rotation.

5. Procédé selon une ou plusieurs des revendications 1 à 4, caractérisé en ce que le silicium solidifié est soumis à un recuit l'amenant entre 900 à 1300°C, avec une vitesse de refroidissement de 0,5 à 30°C/mn, puis est refroidi rapidement à une température inférieure à 700°C et est ensuite évacué par un sas.

6. Dispositif pour la mise en oeuvre du procédé selon les revendications 1 à 5, comportant un poste de coulée étanche au vide, dans lequel un vide peut être réalisé et qui loge un creuset de fusion entouré par un dispositif de chauffage et permettant la libération du silicium et comporte au moins un canal de rechargement séparé par des sas par rapport à l'atmosphère extérieure et aboutissant au creuset de fusion, et un dispositif de réception du moule de coulée, qui permet d'amener le moule de coulée dans la position de coulée, au moins un poste de cristallisation relié au poste de coulée et possédant une source d'énergie appliquant une énergie à la surface libre du silicium situé dans le moule de coulée, un dispositif d'évacuation d'énergie, situé en vis-à-vis de cette source, un dispositif de refroidissement, qui se raccorde au poste de cristallisation, au moins un poste de chargement conduisant au poste de coulée et séparé de ce dernier par des organes de blocage étanches au vide et contenant un poste de préchauffage, de moyens de transport permettant d'amener des, moules de coulée dans les postes désirés, ainsi que des canalisations d'amenée et d'évacuation pour les gaz.

7. Dispositif selon la revendication 6, caractérisé en ce que le poste de chargement est subdivisé en un poste d'insertion et en un poste de préchauffage.

8. Dispositif selon la revendication 6 ou 7, caractérisé en ce que le poste de refroidissement est subdivisé en un poste de recuit et en un poste de refroidissement rapide.

9. Dispositif selon une ou plusieurs des revendications 6 à 8, caractérisé en ce que le creuset de fusion ainsi que, dans un plan sous-jacent, un dispositif de réception pour le moule de coulée, un poste de cristallisation et un poste de recuit sont disposés, à la manière d'un plateau rotatif, dans une tour de coulée reliée par l'intermédiaire d'un poste de transfert à une section de chargement et de déchargement.

10. Dispositif selon une ou plusieurs des revendications 6 à 9, caractérisé en ce que pour l'étape opératoire partielle qui requiert respectivement le plus de temps, il est prévu plusieurs postes de travail branchés en parallèle ou les uns à la suite des autres.

Fig.1

EP 0 172 426 B1

Fig. 2